# EUROPEAN PATENT SPECIFICATION

(11) **EP 2 744 314 B1**
(45) Date of publication and mention of the grant of the patent: **11.03.2015**
(21) Application number: 12196962.0
(22) Date of filing: 13.12.2012
(51) Int. Cl.: H05K 7/14

(54) **Cable Management Arm**
Kabelmanagementarm
Bras de gestion de câbles

(43) Date of publication of application: 18.06.2014
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Huang, Chien-Li, Kaohsiung City (TW); Wang, Chun-Chiang, Kaohsiung City (TW)
(74) Representative: Viering, Jentschura & Partner Patent- und Rechtsanwälte

(56) References cited:
- US-A1- 2005 145 582
- US-A1- 2006 113 433
- US-A1- 2007 017 883
- US-A1- 2009 014 601
- US-A1- 2009 078 834
- US-A1- 2010 193 646
- US-B1- 7 746 667

## Description

### FIELD OF THE INVENTION

The present invention relates to a cable management arm, and more particularly, to a cable supporting device for support the cables.

### BACKGROUND OF THE INVENTION

The conventional cable management arms are disclosed in U.S. Patent No. 7,472,795 B2 to Dubon et al, U.S. Patent No. 7,654,398 B2 to Bridges et al, U.S. Patent No. 7,746,667 B1 to Baiza et al, U.S. Patent No. 7,554,819 B2 to Chen et al, U.S. Patent No. 7,712,615 B2 to Chen et al, U.S. Patent No. 8,231,014 B2 to Chen et al, and U.S. Patent No. 8,251,321 B2 to Chen et al.

However, these cable management arms are not convenient when being installed and operated. The present invention intends to provide an improved cable management arm to improve the shortcomings of the conventional ones.

### SUMMARY OF THE INVENTION

The present invention relates to a cable management arm and comprises a first arm, a second arm, a frame, an extension board, a support seat, a first connection element, a second connection element, a third connection element, a first support member, a second support member, a first resilient member and a slide. The frame is pivotably connected between the first and second arms. The extension board is fixed to the bottom of the frame. The support seat has a support board. The first connection element is connected to the first arm. The second connection element is connected to the second arm. The third connection element is connected to the support seat. The cable management arm is installed to a first slide assembly and a second slide assembly. The first arm is connected to the first slide assembly by the first connection element. The second arm is connected to the first slide assembly by the second connection element. The third connection element is connected to the second slide assembly.

The first support member is pivotably connected to the support seat and contacts the support board of the support seat. The second support member is slidably connected to the first support member and retractable relative to the first support member. The first resilient member is connected between the first and second support members, so that the second support member is pulled relative to the first support member by the first resilient member. The slide is pivotably connected to the bottom of the frame and contacts the extension board. The slide is slidably connected to the second support member. The first arm is located at a fixed first position by the first connection element. The second arm is located at a movable second position by the second connection element. The support seat is located at a fixed third position by the third connection element. When the second connection element of the second arm is moved away from the first connection element of the first arm, the frame is moved away from the support seat by the sliding movement of the slide along the second support member. The slide moves the second support member to extend relative to the first support member, and the first support member swings relative to the support seat.

Preferably, the second support member has a first block which is located corresponding to the slide. The slide contacts the first block and drives the second support member relative to the first support member.

Preferably, the second support member has a second block which is located corresponding to the slide. The slide slides between the first block and the second block.

Preferably, the first support member has a first hook and the second support member has a second hook. The first resilient member is connected between the first and second hooks.

Preferably, the support seat is pivotably connected to the third connection element by a first pivoting member. The first support member is pivotably connected to the support seat by a second pivoting member.

Preferably, a second resilient member is connected between the first support member and the support seat. The first support member is able to return within a pre-set angular range relative to the support seat by the second resilient member.

Preferably, the second resilient member has a scrolling portion which is mounted to the first pivoting member and the scrolling portion has a first resilient leg extending therefrom which contacts the first support member.

Preferably, the support board of the support seat is generally horizontal and has a round periphery whose center is located at the axis of the second pivoting member. A pin is connected to the first support member which is movable along the round periphery of the support seat by the pin.

Preferably, the support seat, the third connection element and the first support member are pivotably connected to each other by the first pivoting member.

Preferably, a second resilient member is connected between the support seat and the first support member, so that the first support member is able to return within a pre-set angular range relative to the support seat by the second resilient member.

Preferably, the support seat has a fixing portion fixed to the second resilient member. The second resilient member has two second resilient legs which contact the two sides of the first support member respectively.

Preferably, the support seat has a curved slot whose center is located at the axis of the first pivoting member. The first support member is movably located in the curved slot by a pin.

Preferably, the extension board has a rib extending downward therefrom and the rib contacts the slide.

Preferably, the thickness of the rib is gradually increased from a middle position/center near an edge of the bottom of the extension board to two sides of the extension board.

Preferably, a stop member is connected to the support seat and has at least one first stop, the third connection element has a first protrusion located corresponding to the at least one first stop. The support seat contacts the first protrusion of the third connection element by the at least one first stop of the stop member.

Preferably, the stop member has an extension arm and a second stop which is connected to the extension arm. The second stop is located to contact one side of the first support member.

Preferably, the stop member has two first stops, two extension arms, and two second stops which are connected to the two extension arms. One of the two first stops contacts the first protrusion of the third connection element. One of the second stops contacts the first support member.

Preferably, each of the two extension arms of the stop member has a triggering portion. The third connection element has a second protrusion which is located corresponding to the triggering portion of one of the two extension arms. The second protrusion contacts the triggering portion to move the second stops away from the first support member.

Preferably, the cable management arm further comprises a first slide assembly and a second slide assembly. The first slide assembly has a first fixed rail and a first movable rail which is longitudinally movable relative to the first fixed rail. The second slide assembly has a second fixed rail and a second movable rail which is longitudinally movable relative to the second fixed rail. The first connection element is connected to the first fixed rail and secured at a first position. The second connection element is connected to the first movable rail and located at a second position which is variable when the first movable rail is moved relative to the first fixed rail. The third connection element is connected to the second fixed rail of the second slide assembly and secured at a third position.

Alternatively, the present invention provides a cable management arm and comprises a first slide assembly having a first fixed rail and a first movable rail which is longitudinally movable relative to the first fixed rail. A second slide assembly has a second fixed rail and a second movable rail which is longitudinally movable relative to the second fixed rail. A first arm is connected to the first fixed rail of the first slide assembly. A second arm is connected to the first movable rail of the first slide assembly. A frame is pivotably connected between the first and second arms. A support seat is connected to the second fixed rail of the second slide assembly. A first support member is pivotably connected to the support seat and contacts the support seat. A second support member is slidably connected to the first support member. A first resilient member is connected between the first and second support members. A slide is pivotably connected to the frame and slidably connected to the second support member. When the first and second slide assemblies are pulled, the second arm moves away from the first arm and hence the angle between the first and second arms is increased, the slide slides along the second support member and away from the support seat. The slide drives the second support member to extend relative to the first support member, so that the first support member swings relative to the support seat. When the first and second slide assemblies are retracted, the second arm moves toward the first arm. The second support member moves in response to the first resilient member and relative to the first support member.

The present invention will become more obvious from the following description when taken in connection with the accompanying drawings which show, for purposes of illustration only, a preferred embodiment in accordance with the present invention.

### BRIEF DESCRIPTION OF THE DRAWINGS

Fig. 1 is an exploded view to show the cable management arm of the present invention;
Fig. 2 is a perspective view to show a part of the cable management arm of the present invention;

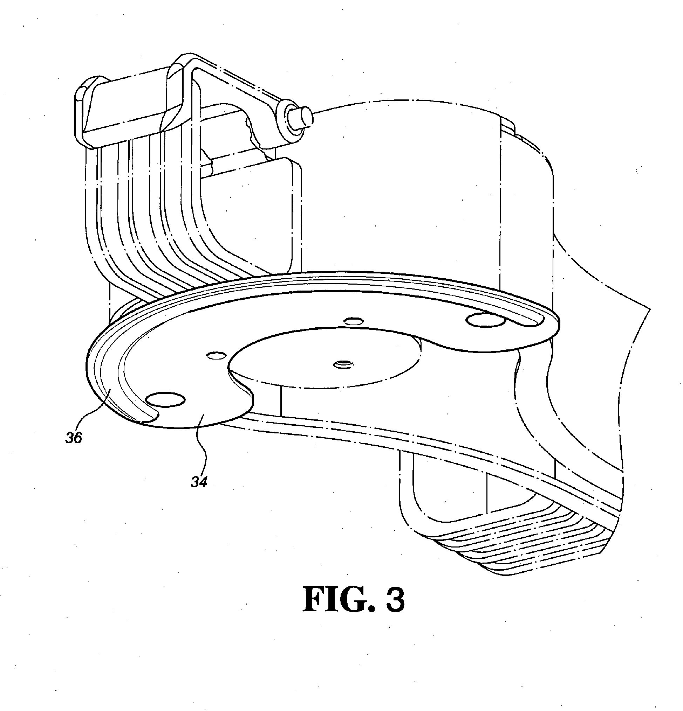

Fig. 3 shows the changes of the thickness of the rib of the extension board of the cable management arm of the present invention;
Fig. 4 shows that the cable management arm of the present invention is located at a retracted position;
Fig. 5 shows that the second connection element of the second arm is located at a first distance relative to the first connection element of the first arm;
Fig. 6 shows that the second connection element of the second arm is located at a second distance relative to the first connection element of the first arm;
Fig. 7 shows that the second connection element of the second arm is located at a third distance relative to the first connection element of the first arm;
Fig. 8 shows that the second connection element of the second arm is located at a fourth distance relative to the first connection element of the first arm;
Fig. 9 shows that the first type of the stop member contacts the first support member;
Fig. 10 shows that the second type of the stop member contacts the first support member;
Fig. 11 shows that the third connection element contacts the second type of the stop member in different directions;
Fig. 12 shows that another type of the second resilient member contacts the first support member, and
Fig. 13 shows another connecting relation among the support seat, the first support member and the third connection element.

### DETAILED DESCRIPTION OF THE PREFERRED EMBODIMENT

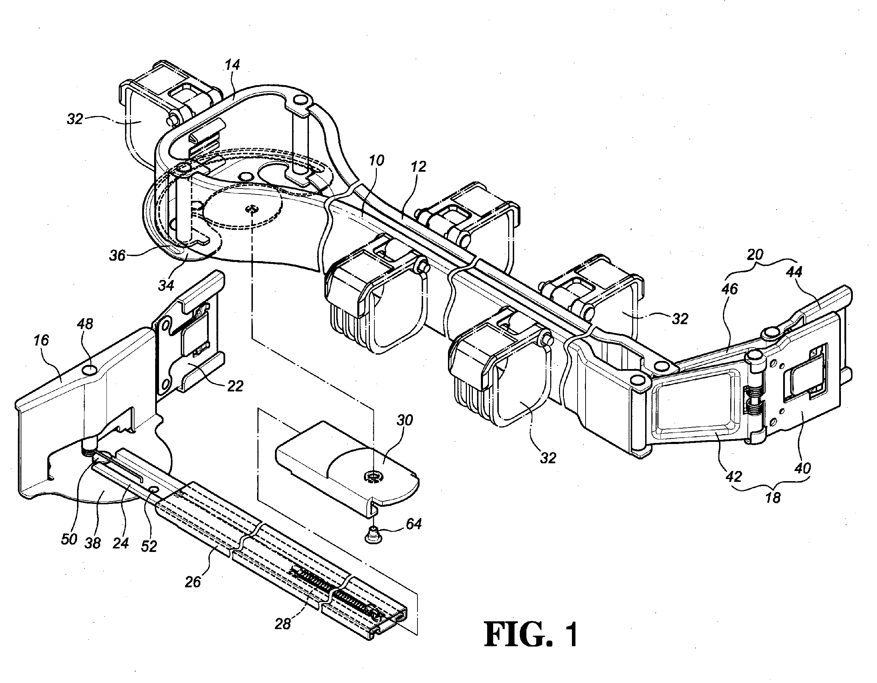

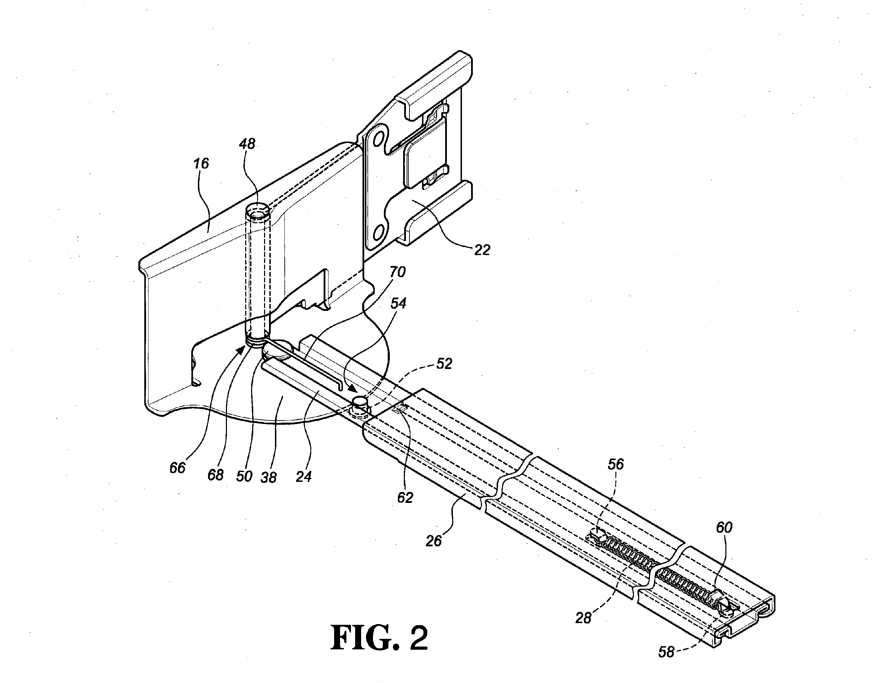

Referring to Figs. 1 and 2, the cable management arm of the present invention comprises a first arm 10, a second arm 12, a frame 14, a support seat 16, a first connection element 18, a second connection element 20, a third connection element 22, a first support member 24, a second support member 26, a first resilient member 28, a slide 30 and multiple cable supports 32. The cable supports 32 are located on the first arm 10, the second arm 12 and the frame 14 so as to support cables (not shown).

The frame 14 is pivotably connected between the first and second arms 10, 12, and has an extension board 34. In a preferable embodiment, the extension board 34 is an individual board and fixed to the lower portion/bottom of the frame 14. Alternatively, the extension board 34 is integrally formed with the frame 14. The extension board 34 has a rib 36 extending downward therefrom and the thickness of the rib 36 is gradually increased from a center near an edge of the bottom of the extension board 34 to two sides of the extension board 34.

The support seat 16 has a support board 38. Preferably, the support board 38 is generally horizontal and has a round periphery.

The first connection element 18 is connected to the first arm 10 and has a first engaging member 40 and a first connection plate 42 which is pivotably connected to the first engaging member 40. In a preferable embodiment, the first connection plate 42 is pivotably connected to the first arm 10.

The second connection element 20 is connected to the second arm 12 and has a second engaging member 44 and a second connection plate 46 which is pivotably connected to the second engaging member 44. In a preferable embodiment, the second connection plate 46 is pivotably connected to the second arm 12.

The third connection element 22 is pivotably connected to the support seat 16 by a first pivoting member 48.

The first support member 24 is pivotably connected to and contacts the support board 38 of the support seat 16 by a second pivoting member 50. The first support member 24 has a pin 52 connected thereto and the support board 38 of the support seat 16 has a round periphery whose center is located at the axis of the second pivoting member 50. When the first support member 24 swings relative to the support seat 16, the first support member 24 is movable along the round periphery of the support board 38 of the support seat 16 by the pin 52. As shown in Fig. 2, the first support member 24 has a path 54 and a first hook 56, wherein the path 54 is formed along the length of the first support member 24 and the first hook 56 extends from the wall of the path 54.

The second support member 26 is slidably connected to the first support member 24 and retractable relative to the first support member 24. As shown in Fig. 2, the second support member 26 has a second hook 58 which extends toward the path 54 of the first support member 24. A first block 60 and a second block 62 are connected on two ends of the second support member 26.

The first resilient member 28 is connected between the first hook 56 of the first support member 24 and the second hook 58 of the second support members 26, so that the second support member 26 is pulled relative to the first support member 24 by the first resilient member 28. In other words, the second support member 26 is movable relative to the first support member 24 in response to the force of the first resilient member 28. For example, the second support member 26 is pulled back from an extended position to a retracted position relative to the first support member 24 by the first resilient member 28.

The slide 30 is pivotably connected to the lower portion/bottom of the frame 14 by a pivot 64 and contacts the extension board 34. The slide 30 is slidably connected between the first and second blocks 60, 62 of the second support member 26. It is noted that the extension board 34 can be treated as a part of the frame 14. In other words, the slide 30 can be treated as being pivotably connected to the extension board 34. Preferably, the pivot 64 extends through the slide 30 and the frame 14, and the slide 30 contacts the rib 36 of the extension board 34. Therefore, the connection of the slide 30 and the extension board 34 has a pressing force therebetween in vertical direction. Especially, when the range that the slide 30 swings relative to the frame 14 increases, the thickness of the rib 36 is gradually increased such that the pressing force is increased. The rib 36 contacts against the slide 30, so that the slide 30 is secured to the frame 14. When the slide 30 moves to the distal end of the second support member 26, the slide 30 contacts the first block 60 and drives the second support member 26 to slidingly extend relative to the first support member 24.

In one preferable embodiment, as shown in Fig. 2, a second resilient member 66 is connected between the first support member 24 and the support seat 16, so that the first support member 24 returns within a pre-set angular range relative to the support seat 16 by the second resilient member 66. The second resilient member 66 has a scrolling portion 68 which is mounted to the first pivoting member 48, and the scrolling portion 68 has a first resilient leg 70 extending therefrom which contacts the first support member 24.

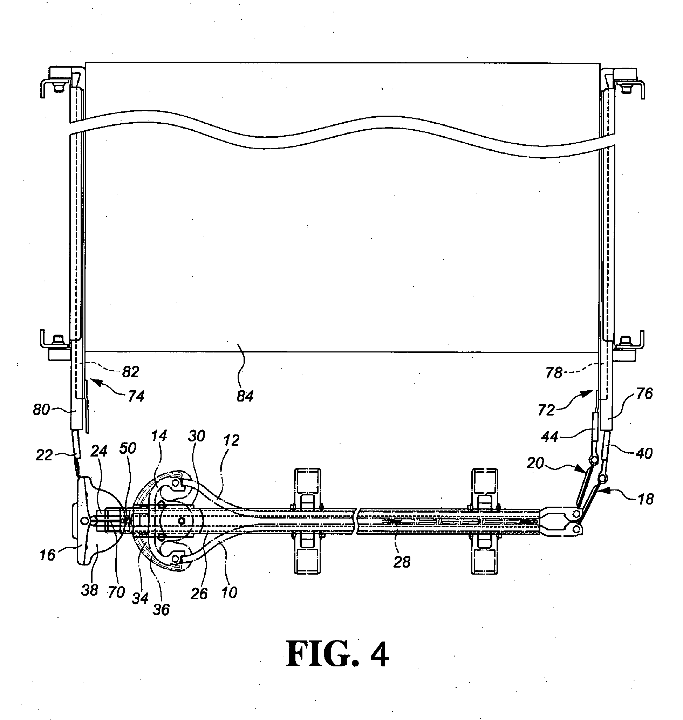

Fig. 4 shows that the cable management arm is installed to the first and second slide assemblies 72, 74. The first slide assembly 72 has a first fixed rail 76 and a first movable rail 78 which is longitudinally movable relative to the first fixed rail 76. The second slide assembly 74 has a second fixed rail 80 and a second movable rail 82 which is longitudinally movable relative to the second fixed rail 80. A servo equipment 84 is connected between the first and second movable rails 78, 82, and the cables (not shown) of the servo equipment 84 are supported by the first arm 10, the second arm 12 and the frame 14. The first arm 10 is connected to the first fixed rail 76 of the first slide assembly 72 by the first engaging member 40 of the first connection element 18, and one end of the first arm 10 is secured at a first position. The second arm 12 is connected to the first movable rail 78 of the first slide assembly 72 by the second engaging member 44 of the second connection element 20. One end of the second arm 12 is located at a second position which is variable when the first movable rail 78 is moved relative to the first fixed rail 76. The third connection element 22 is connected to the second fixed rail 80 of the second slide assembly 74 to secure the support seat 16 at a third position.

As shown in Fig. 4, when the first and second slide assemblies 72, 74 are in the retracted position, the second arm 12 is located close to the first arm 10, so that the weight center of the whole cable management arm is located close to the frame 14. Wherein, in the retracted position, the second support member 26 is retracted relative to the first support member 24, and the first support member 24 contacts the support board 38 of the support seat 16. Further, the frame 14 is located adjacent to the support seat 16 by the sliding movement of the slide 30 along the second support member 26. Therefore, in the retracted position, the first and second arms 10, 12 are mainly supported by the support seat 16.

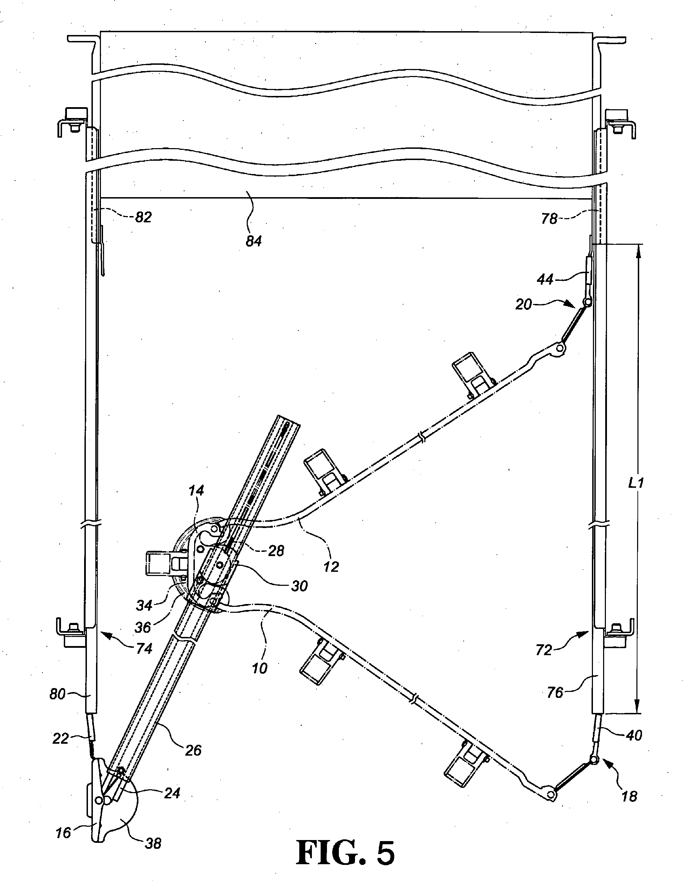

Fig. 5 shows that the first movable rail 78 and the second movable rail 82 are initially extended, the second connection element 20 of the second arm 12 moves a first distance L1 relative to the first connection element 18 of the first arm 10. Wherein, the second support member 26 has not yet extended away from the first support member 24. The frame 14 and the extension board 34 are linearly moved linearly by the sliding movement of the slide 30 along the second support member 26, so that the frame 14 is moved with the second arm 12 longitudinally. The frame 14 drives the first support member 24 to swing relative to the support seat 16 by the slide 30 and the second support member 26. In the meanwhile, the slide 30 swings relative to the frame 14 and the extension board 34. Along with the increased range of the swinging of the slide 30 with the extension board 34, the gradually increasing thickness of the rib 36 contacts the slide 30 to maintain the secure connection between the slide 30 and the extension board 34. Therefore, even if the weight center of the cable management arm is moved from the support seat 16 to the second support member 26, the support seat 16 and the second support member 26 (including the first support member 24) can provide a firm support to the cable management arm.

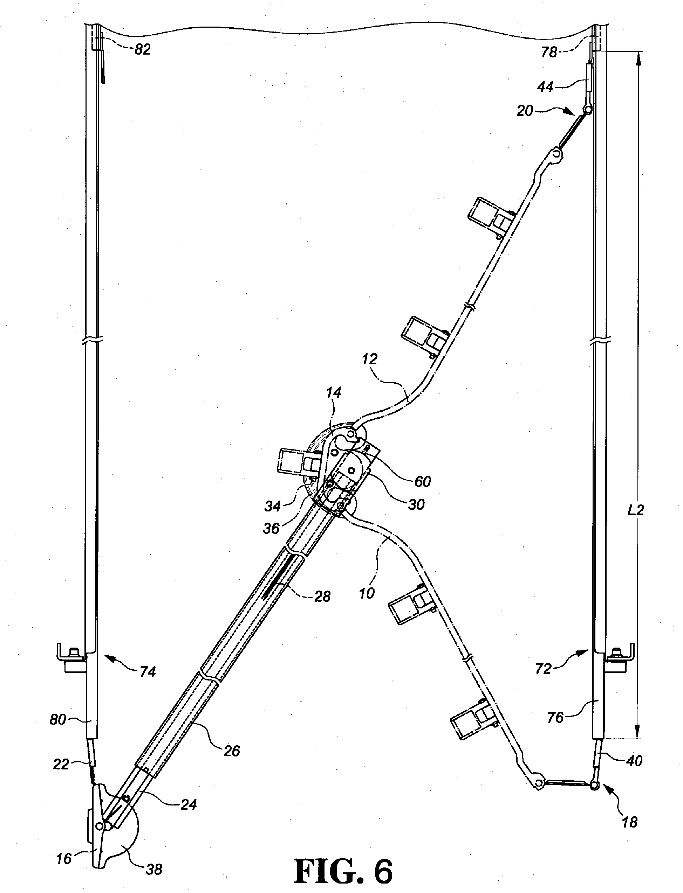

Fig. 6 shows that the second connection element 20 of the second arm 12 moves a second distance L2 relative to the first connection element 18 of the first arm 10. The frame 14 and the extension board 34 are moved to the first block 60 by the sliding movement of the slide 30 along the second support member 26. When the slide 30 contacts the first block 60, the slide 30 drives the second support member 26 to extend relative to the first support member 24, and the first support member 24 swings relative to the support seat 16. In the meanwhile, the first resilient member 28 is extended by the second support member 26 and generates a force to pull the second support member 26. The frame 14 is located away from the support seat 16 and moves toward the first slide assembly 72, and the frame 14 is located close to the mediate position of the transverse distance between the first and second slide assemblies 72, 74. Wherein, the weight that is supported by the cable management arm is gradually shared by the first and second arms 10, 12. The first and second support members 24, 26 are supported by the support seat 16 and share the weight that is supported by the first and second arms 10, 12. In this status, the truss-like structure, formed by the second support member 26, the first support member 24, the first arm 10 and the second arm 12, supports and share the weight that is supported by the cable management arm with good supporting effect.

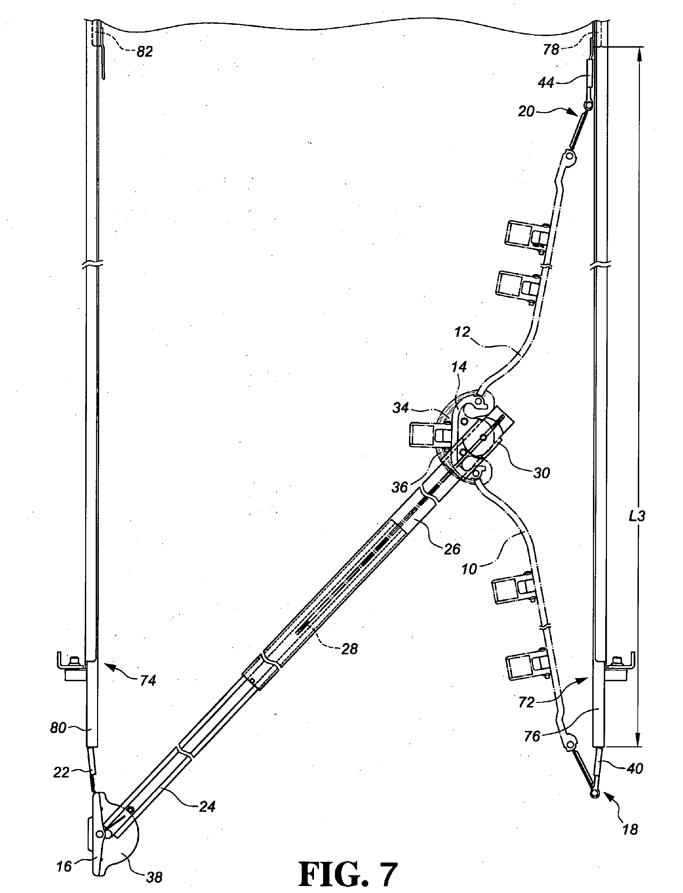

Fig. 7 shows that the second connection element 20 of the second arm 12 moves a third distance L3 relative to the first connection element 18 of the first arm 10. The frame 14 and the extension board 34 are moved by the slide 30 and the second support member 26 is further extended relative to the first support member 24. The first support member 24 swings an even larger angle relative to the support seat 16. The first resilient member 28 continuously provides a pulling force to the second support member 26. The frame 14 moves beyond the mediate position of the transverse distance between the first and second slide assemblies 72, 74, and comes close to the first slide assembly 72. Therefore, the weight of the cable management arm is mostly supported by the first and second arms 10, 12, and the weight applied to the first and second support members 24, 26 is reduced.

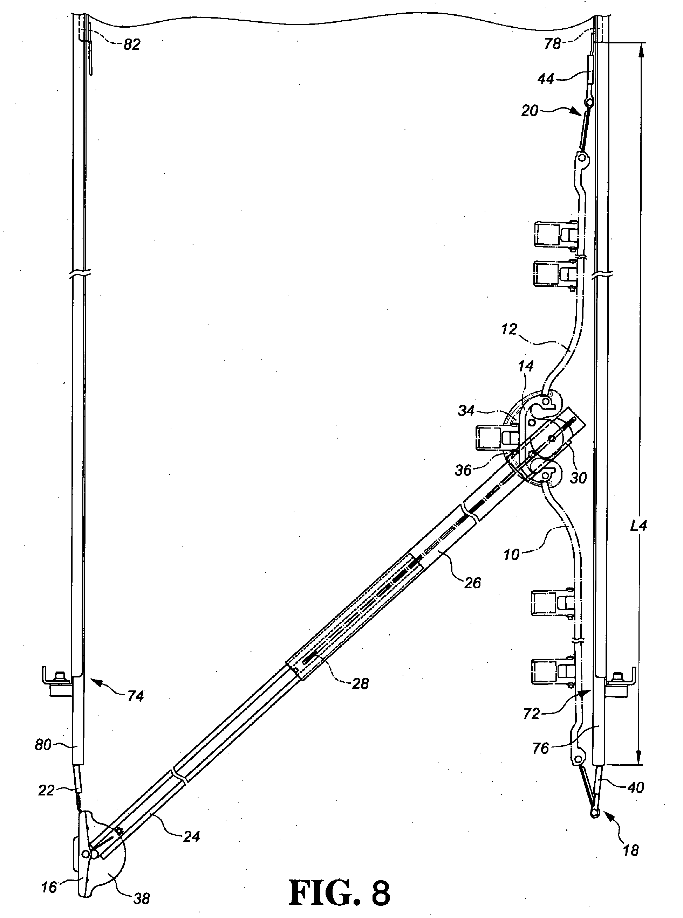

Fig. 8 shows that the second connection element 20 of the second arm 12 moves a fourth distance L4, preferably is fully extended, relative to the first connection element 18 of the first arm 10. The frame 14 and the extension board 34 are moved by the slide 30 and the second support member 26 is fully extended relative to the first support member 24. The first support member 24 swings relative to the support seat 16. In the meanwhile, the second support member 26 keeps being pulled by the first resilient member 28. In this status, the frame 14 is located very close to the first rail assembly 72, so that most of the weight of the cable management arm is supported by the first and second arms 10, 12. Wherein, the first and second support members 24, 26 are supported by the frame 14.

It is noted that during the retracting process of the cable management arm, in response to the pulling force of the first resilient member 28, the second support member 26 is automatically pulled backward relative to the first support member 24. In other words, when the slide 30 moves along the second support member 26 and toward the support seat 16, the second support member 26 is automatically retracted relative to the first support member 24. When the first block 60 contacts the slide 30, the movement of the slide 30 and the retraction of the second support member 26 is simultaneously. On the other hand, the first support member 24 automatically pivoted relative to the support seat 16 by the force of the second resilient member 66, so that the cable management arm is retracted back to the desired angular range. Even if the force of the second resilient member 66 is not exist, when the first and second support members 24, 26 are retracted, the sliding movement of the slide 30 along the second support member 26 can drive the first support member 24 to swing back to the pre-set/desired angular range.

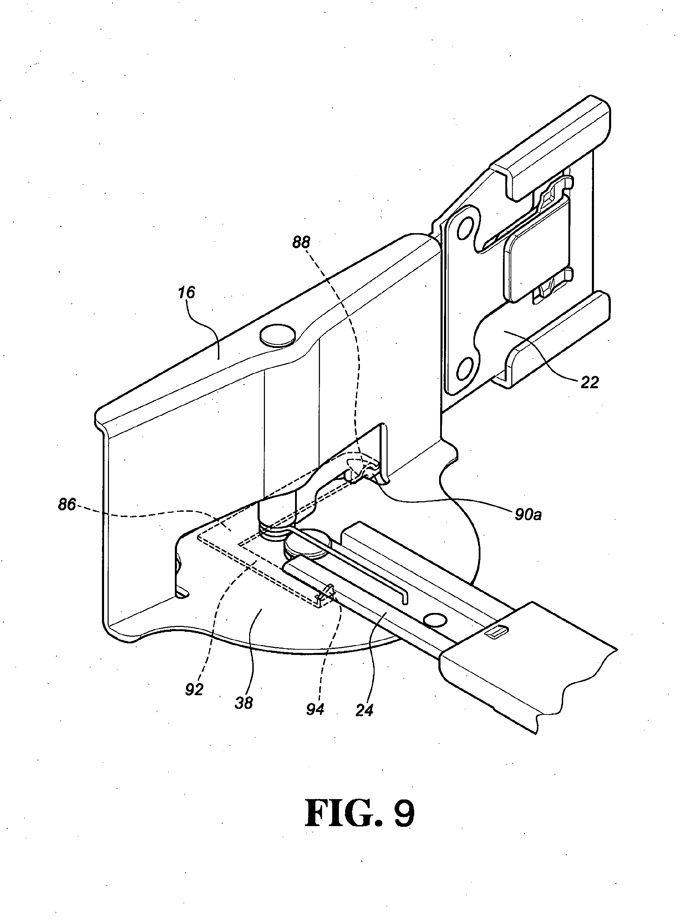

Fig. 9 shows a first type of a stop member 86 of the present invention. The stop member 86 is connected to the support seat 16 and has at least one first stop 88. The third connection element 22 has a first protrusion 90a located corresponding to the at least one first stop 88. The support seat 16 contacts the first protrusion 90a of the third connection element 22 by the at least one first stop 88 of the stop member 86, so that the connection between the support seat 16 and the third connection element 22 is secured and does not swing or shift. Wherein, the stop member 86 further comprises an extension arm 92 and a second stop 94 which is connected to the extension arm 92. The second stop 94 is located to contact one side of the first support member 24, so that the first support member 24 can only swing toward the third connection element 22.

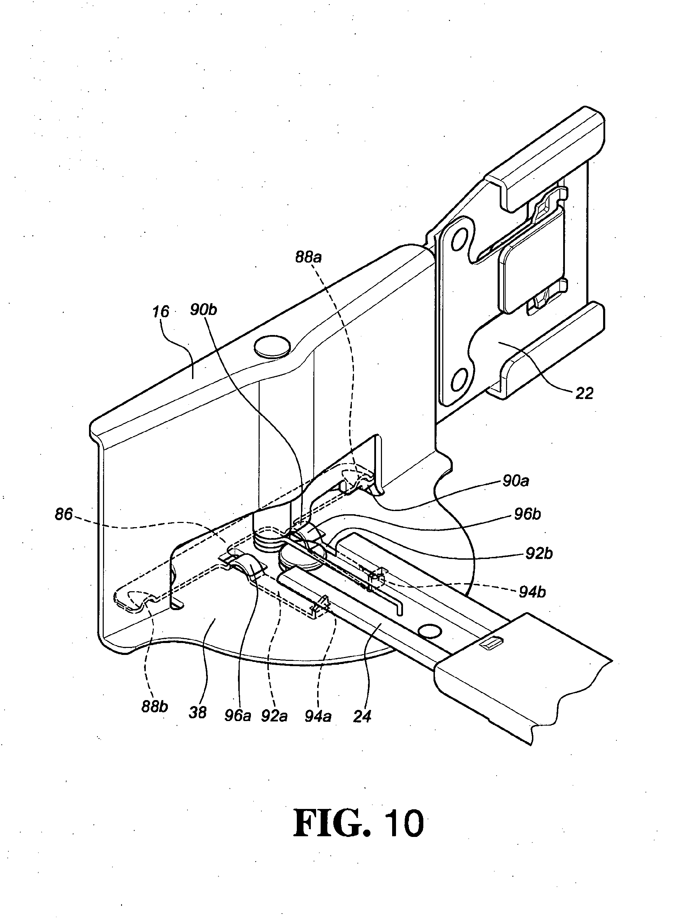

Fig. 10 shows the second type of the stop member 86 of the present invention. The stop member 86 has two first stops 88a, 88b, two extension arms 92a, 92b, and two second stops 94a, 94b which are respectively and correspondingly connected to the two extension arms 92a, 92b. One of the two first stops 88a, 88b (such as the first stop 88a in Fig. 10) contacts the first protrusion 90a of the third connection element 22. One of the second stops 94a, 94b (such as the second stop 94a in Fig. 10) contacts the first support member 24. Each of the two extension arms 92a, 92b of the stop member 86 has a triggering portion 96a/96b. The third connection element 22 has a second protrusion 90b which is located corresponding to the triggering portion 96b of one of the two extension arms 92a, 92b (such as the extension arm 92b in Fig. 10). The second protrusion 90b contacts the triggering portion 96b to move the second stop 94b away from the first support member 24. By this arrangement, the first support member 24 can only swing toward the third connection element 22.

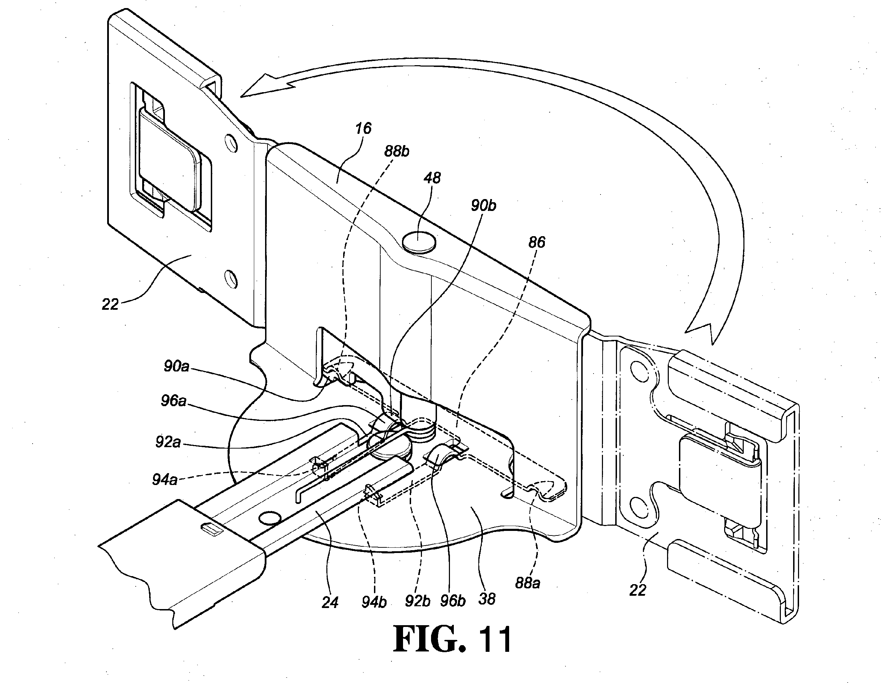

In Fig. 10, the first stops 88a, 88b, the extension arms 92a, 92b and the second stops 94a, 94b of the stop member 86 are in pair and symmetrically arrangement, so that the third connection element 22 can be installed on the right side or the left side relative to the support seat 16. As shown in Fig. 11, when the third connection element 22 is pivoted about the first pivoting member 48 and change the position from the side (as illustrated by the dotted lines) of the support seat 16 to the other side (as illustrated by the solid lines) of the support seat 16, the first stop 88a of the stop member 86 can be pressed and disengaged from the first protrusion 90a of the third connection element 22, so that the third connection element 22 is turnable. After the third connection element 22 turns, the other stop 88b of the stop member 86 contacts the first protrusion 90a of the third connection element 22 to secure the relative position between the support seat 16 and the third connection element 22. Wherein, the second protrusion 90b of the third connection element 22 presses the triggering portion 96a of the other extension arm 92a to remove the second stop 94a from the first support member 24. By this way, the first support member 24 swings toward the third connection element 22, and the first support member 24 is stopped by the second stop 94b of the stop member 86 and cannot swing toward the opposite direction of the third connection element 22.

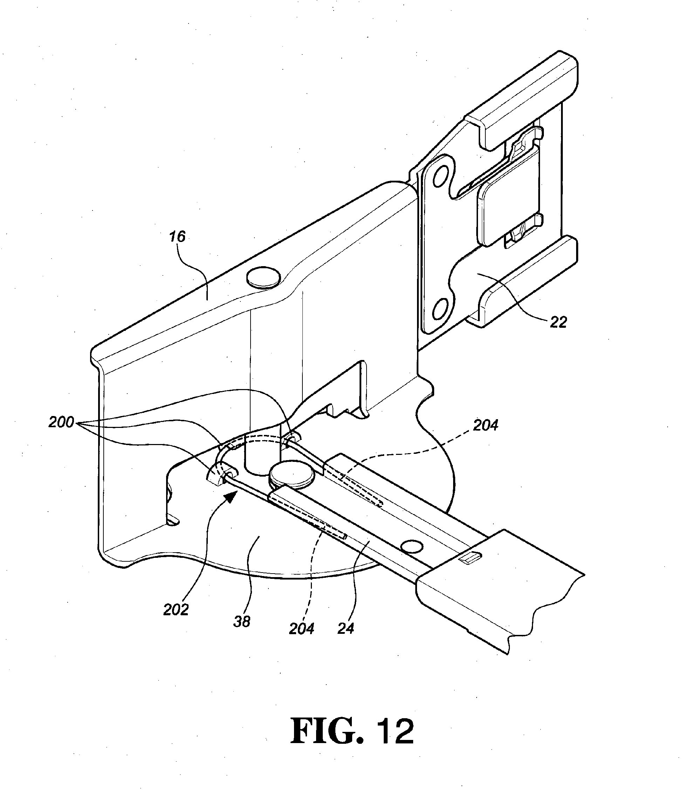

Fig. 12 shows another type of the second resilient member 202 of the present invention, wherein the support seat 16 has a fixing portion 200 so that the second resilient member 202 can be fixed to the support seat 16. The second resilient member 202 has two second resilient legs 204 which contact the two sides of the first support member 24 respectively, so that the first support member 24 can be pivoted within a pre-set angular range relative to the support seat 16 by the force of the second resilient member 202.

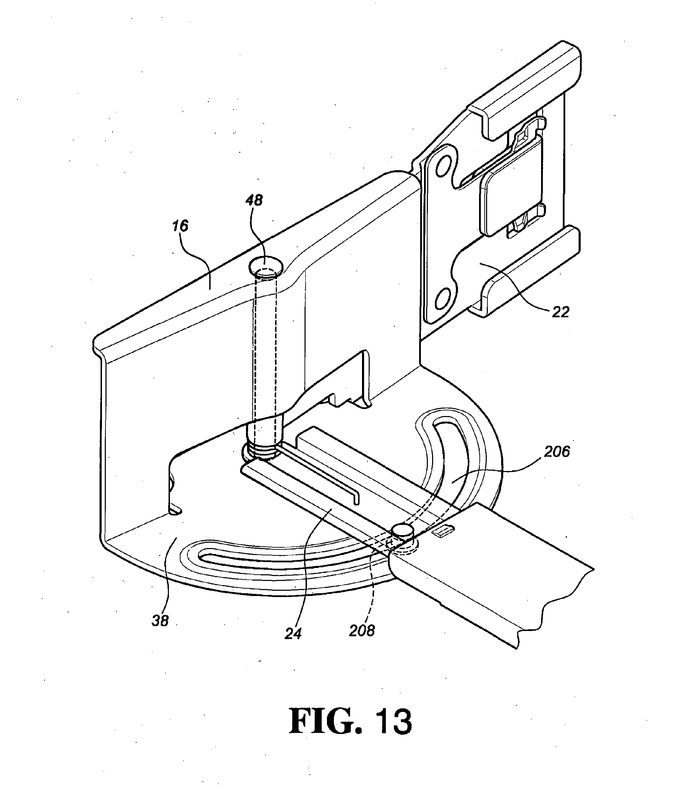

Fig. 13 shows another connecting relation among the support seat 16, the first support member 24 and the third connection element 22 of the present invention. The support seat 16 has a curved slot 206 whose center is located at the axis of the first pivoting member 48. The first support member 24 is movably located in the curved slot 206 by a pin 208. When the first support member 24 swings relative to the support seat 16, the pin 208 moves along the curved slot 206. Wherein, the first support member 24, the support seat 16 and the third connection element 22 are pivotably connected to each other by the first pivoting member 48.

As the foregoing embodiments of the present invention shown, the cable management arm provides a firm support when the cable management arm is in the retracted status (as shown in Fig. 4). When the cable management arm is in the extended status (as shown in Figs. 5-8), the weight of the cable management arm is well supported, so that the cable management arm does not overly bend downward due to gravity.

While we have shown and described the embodiment in accordance with the present invention, it should be clear to those skilled in the art that further embodiments may be made without departing from the scope of the present invention.

## Claims

1. A cable management arm comprising:
a first arm (10);
a second arm (12);
a frame (14) pivotably connected between the first and second arms (10, 12);
an extension board (34) fixed to the bottom of the frame (14);
a support seat (16) having a support board (38);
a first connection element (18) connected to the first arm (10);
a second connection element (20) connected to the second arm (12);
a third connection element (22) connected to the support seat (16);
the cable management arm installed to a first slide assembly (72) and a second slide assembly (74);
the first arm (10) connected to the first slide assembly (72) by the first connection element (18);
the second arm (12) connected to the first slide assembly (72) by the second connection element (20); and
the support seat (16) connected to the second slide assembly (74) by the third connection element (22);
a first support member (24) pivotably connected to the support seat (16) and contacting the support board (38) of the support seat (16);
a second support member (26) slidably connected to the first support member (24) and retractable relative to the first support member (24);
a first resilient member (28) connected between the first and second support members (24, 26) so that the second support member (26) is pulled relative to the first support member (24) by the first resilient member (28);
a slide (30) pivotably connected to the bottom of the frame (14) and contacting the extension board (34), the slide (30) slidably connected to the second support member (26), and
the first arm (10) being located at a fixed first position by the first connection element (18), the second arm (12) being located at a movable second position by the second connection element (20), the support seat (16) being located at a fixed third position by the third connection element (22), when the second connection element (20) of the second arm (12) is moved away from the first connection element (18) of the first arm (10), the frame (14) is moved away from the support seat (16) by sliding movement of the slide (30) along the second support member (26), the slide (30) moves the second support member (26) to extend relative to the first support member (24), and the first support member (24) swings relative to the support seat (16).

2. The cable management arm as claimed in claim 1, wherein the second support member (26) has a first block (60) which is located corresponding to the slide (30), the slide (30) contacts the first block (60) and drives the second support member (26) to move relative to the first support member (24).

3. The cable management arm as claimed in claim 2, wherein the second support member (26) has a second block (62) which is located corresponding to the slide (30), the slide (30) slides between the first block (60) and the second block (62).

4. The cable management arm as claimed in claim 1, wherein the first support member (24) has a first hook (56) and the second support member (26) has a second hook (58), the first resilient member (28) is connected between the first and second hooks (56, 58).

5. The cable management arm as claimed in claim 1, wherein the support seat (16) is pivotably connected to the third connection element (22) by a first pivoting member (48), the first support member (24) is pivotably connected to the support seat (16) by a second pivoting member (50).

6. The cable management arm as claimed in claim 5, further comprising a second resilient member (66) connected between the first support member (24) and the support seat (16), the first support member (24) returns within a pre-set angular range relative to the support seat (16) by the second resilient member (66).

7. The cable management arm as claimed in claim 6, wherein the second resilient member (66) has a scrolling portion (68) which is mounted to the first pivoting member (48) and the scrolling portion (68) has a first resilient leg (70) extending therefrom which contacts the first support member (24).

8. The cable management arm as claimed in claim 5, wherein the support board (38) of the support seat (16) is horizontal and has a round periphery whose center is located at an axis of the second pivoting member (50), a pin (52) is connected to the first support member (24) which is movable along the round periphery of the support seat (16) by the pin (52).

9. The cable management arm as claimed in claim 1, wherein the support seat (16), the third connection element (22) and the first support member (24) are pivotably connected to each other by the first pivoting member (48).

10. The cable management arm as claimed in claim 9, further comprising a second resilient member (202) connected between the support seat (16) and the first support member (24), so that the first support member (24) returns within a pre-set angular range relative to the support seat (16) by the second resilient member (202).

11. The cable management arm as claimed in claim 10, wherein the support seat (16) has a fixing portion (200) to fix the second resilient member (202), the second resilient member (202) has two second resilient legs (204) which contact the two sides of the first support member (24) respectively.

12. The cable management arm as claimed in claim 9, wherein the support seat (16) has a curved slot (206) whose center is located at an axis of the first pivoting member (48), the first support member (24) is movably located in the curved slot (206) by a pin (208).

13. The cable management arm as claimed in claim 1, wherein the extension board (34) has a rib (36) extending downward therefrom and the rib (36) contacts the slide (30).

14. The cable management arm as claimed in claim 13, wherein the thickness of the rib (36) is gradually increased from a center near an edge of the bottom of the extension board (34) to two sides of the extension board (34).

15. The cable management arm as claimed in claim 1, wherein a stop member (86) is connected to the support seat (16) and has at least one first stop (88), the third connection element (22) has a first protrusion (90a) located corresponding to the at least one first stop (88), the support seat (16) contacts the first protrusion (90a) of the third connection element (22) by the at least one first stop (88) of the stop member (86).

16. The cable management arm as claimed in claim 15, wherein the stop member (86) has an extension arm (92) and a second stop (94) which is connected to the extension arm (92), the second stop (94) is located to contact one side of the first support member (24).

17. The cable management arm as claimed in claim 15, wherein the stop member (86) has two first stops (88a, 88b), two extension arms (92a, 92b), and two second stops (94a, 94b) which are connected to the two extension arms (92a, 92b), one of the two first stops (88a, 88b) contacts the first protrusion (90a) of the third connection element (22), one of the second stops (94a, 94b) contacts the first support member (24).

18. The cable management arm as claimed in claim 17, wherein each of the two extension arms (92a, 92b) of the stop member (86) has a triggering portion (96a/96b), the third connection element (22) has a second protrusion (90b) which is located corresponding to the triggering portion (96a/96b) of one of the two extension arms (92a, 92b), the second protrusion (90b) contacts the triggering portion (96a/96b) to move the second stops (94a, 94b) away from the first support member (24).

19. The cable management arm as claimed in claim 1 further comprising a first slide assembly (72) and a second slide assembly (74), the first slide assembly (72) having a first fixed rail (76) and a first movable rail (78) which is longitudinally movable relative to the first fixed rail (76), the second slide assembly (74) having a second fixed rail (80) and a second movable rail (82) which is longitudinally movable relative to the second fixed rail (80), the first connection element (18) connected to the first fixed rail (76) and secured at the first position, the second connection element (20) connected to the first movable rail (78) and located at the second position which is variable when the first movable rail (78) is moved relative to the first fixed rail (76), the third connection element (22) connected to the second fixed rail (80) of the second slide assembly (74) and secured at the third position.

## Patentansprüche

1. Ein Ausleger zum Verstauen eines Kabels, aufweisend:
einem ersten Ausleger (10);
einem zweiten Ausleger (12);
einem Rahmen (14), der drehgelenkig zwischen dem ersten und dem zweiten Ausleger (10, 12) befestigt ist;
einem verlängerten Plättchen (34), das auf der Unterseite des Rahmens (14) befestigt ist;
einem Trägersitz (16) mit einem Trägerplättchen (38);
einem ersten Befestigungselement (18), der am ersten Ausleger (10) befestigt ist;
einem zweiten Befestigungselement (20), der am zweiten Ausleger (12) befestigt ist;
einem dritten Befestigungselement (22), der am Trägersitz (16) befestigt ist;
der Ausleger zum Verstauen eines Kabels an einem ersten gleitbaren Mechanismus (72) montiert ist; und
einem zweiten gleitbaren Mechanismus (74);
der erste Ausleger (10) über das erste Befestigungselement (18) am ersten gleitbaren Mechanismus (72) befestigt ist;
der zweite Ausleger (12) über das zweite Befestigungselement (20) am ersten gleitbaren Mechanismus (72) befestigt ist; und
das dritte Befestigungselement (22) über den Trägersitz (16) am zweiten gleitbaren Mechanismus (74) befestigt ist;
ein erstes Stützteil (24) drehgelenkig am Trägersitz (16) befestigt ist und mit dem Trägerplättchen (38) dieses Trägersitzes (16) in Berührung kommt;
ein zweites Stützteil (26) gleitbar am ersten Stützteil (24) befestigt ist und in dieses erste Stützteil (24) eingezogen werden kann;
eine erste Feder (28) zwischen dem ersten und dem zweiten Stützteil (24, 26) befestigt ist, um dieses zweite Stützteil (26) mit dieser ersten Feder (28) relativ zum ersten Stützteil (24) zu ziehen;
ein Gleitstück (30) drehgelenkig auf der Unterseite des Rahmens (14) befestigt ist und mit dem verlängerten Plättchen (34) in Berührung kommt, wobei dieses Gleitstück (30) gleitbar am zweiten Stützteil (26) befestigt ist; und
der erste Ausleger (10) mit dem ersten Befestigungselement (18) in einer festen ersten Position angeordnet ist; der zweite Ausleger (12) mit dem zweiten Befestigungselement (20) in einer beweglichen zweiten Position angeordnet ist; der Trägersitz (16) mit dem dritten Befestigungselement (22) in einer festen dritten Position angeordnet ist; beim Wegbewegen des zweiten Befestigungselements (20) des zweiten Auslegers (12) vom ersten Befestigungselement (18) des ersten Auslegers (10) der Rahmen (14) durch die Gleitbewegung des Gleitstückes (30) zusammen mit dem zweiten Stützteil (26) vom Trägersitz (16) wegbewegt wird; das zweite Stützteil (26) mit dem Gleitstück (30) bewegt wird, um relativ zum ersten Stützteil (24) eine Verlängerung zu bilden, wobei dieses erste Stützteil (24) relativ zum Trägersitz (16) geschwenkt wird.

2. Der Ausleger zum Verstauen eines Kabels nach Anspruch 1, wobei das zweite Stützteil (26) einen ersten Block (60) aufweist, der entsprechend dem Gleitstück (30) angeordnet ist, wobei dieses Gleitstück (30) mit diesem ersten Block (60) in Berührung kommt und das zweite Stützteil (26) antreibt, um dieses relativ zum ersten Stützteil (24) zu bewegen.

3. Der Ausleger zum Verstauen eines Kabels nach Anspruch 2, wobei das zweite Stützteil (26) einen zweiten Block (62) aufweist, der entsprechend dem Gleitstück (30) angeordnet ist, wobei dieses Gleitstück (30) zwischen dem ersten Block (60) und dem zweiten Block (62) gleitet.

4. Der Ausleger zum Verstauen eines Kabels nach Anspruch 1, wobei das erste Stützteil (24) einen ersten Haken (56) und das zweite Stützteil (26) einen zweiten Haken (58) aufweisen; die erste Feder (28) zwischen dem ersten und dem zweiten Haken (56, 58) befestigt ist.

5. Der Ausleger zum Verstauen eines Kabels nach Anspruch 1, wobei der Trägersitz (16) über ein erstes drehgelenkiges Element (48) drehgelenkig am dritten Befestigungselement (22) und das erste Stützteil (24) über ein zweites drehgelenkiges Element (50) drehgelenkig am Trägersitz (16) befestigt sind.

6. Der Ausleger zum Verstauen eines Kabels nach Anspruch 5, weiter bestehend aus einer zweiten Feder (66), die zwischen dem ersten Stützteil (24) und dem Trägersitz (16) befestigt ist, so dass das erste Stützteil (24) mit der zweiten Feder (66) innerhalb eines vorbestimmten Winkels relativ zum Trägersitz (16) zurückbewegt wird.

7. Der Ausleger zum Verstauen eines Kabels nach Anspruch 6, wobei die zweite Feder (66) ein rollbares Teil (68) aufweist, das am ersten drehgelenkigen Teil (48) montiert ist, wobei sich von diesem rollbaren Teil (68) ein erster elastischer Fuss (70) erstreckt, der mit dem ersten Stützteil (24) in Berührung kommt.

8. Der Ausleger zum Verstauen eines Kabels nach Anspruch 5, wobei das Trägerplättchen (38) des Trägersitzes (16) horizontal positioniert ist und eine runde Peripherie aufweist, deren Mitte sich an einer Achse des zweiten drehgelenkigen Elements (50) befindet; ein Stift (52) am ersten Stützteil (24) befestigt ist, das mit diesem Stift (52) um die runde Peripherie des Trägersitzes (16) beweglich ist.

9. Der Ausleger zum Verstauen eines Kabels nach Anspruch 1, wobei der Trägersitz (16), das dritte Befestigungselement (22) und das erste Stützteil (24) über das erste drehgelenkige Element (48) drehgelenkig aneinander befestigt sind.

10. Der Ausleger zum Verstauen eines Kabels nach Anspruch 9, weiter bestehend aus einer zweiten Feder (202), die zwischen dem Trägersitz (16) und dem ersten Stützteil (24) befestigt ist, so dass das erste Stützteil (24) mit der zweiten Feder (202) innerhalb eines vorbestimmten Winkels relativ zum Trägersitz (16) zurückbewegt wird.

11. Der Ausleger zum Verstauen eines Kabels nach Anspruch 10, wobei der Trägersitz (16) ein Befestigungsteil (200) aufweist, um mit diesem die zweite Feder (202) zu befestigen, wobei diese zweite Feder (202) zwei elastische Füße (204) aufweist, die mit je einer der beiden Seiten des ersten Stützteils (24) in Berührung kommen.

12. Der Ausleger zum Verstauen eines Kabels nach Anspruch 9, wobei der Trägersitz (16) eine gekurvte Nut (206) aufweist, deren Mitte sich an einer Achse des ersten drehgelenkigen Elements (48) befindet, wobei das erste Stützteil (24) mit einem Stift (208) beweglich in dieser gekurvten Nut (206) aufgenommen ist.

13. Der Ausleger zum Verstauen eines Kabels nach Anspruch 1, wobei das verlängerte Plättchen (34) eine Rippe (36) aufweist, die sich von diesem verlängerten Plättchen (34) nach unten erstreckt und dabei diese Rippe (36) mit dem Gleitstück (30) in Berührung kommt.

14. Der Ausleger zum Verstauen eines Kabels nach Anspruch 13, wobei die Dicke der Rippe (36) von einer Mitte nahe zu einer Kante der Unterseite des verlängerten Plättchens (34) nach beiden Seiten dieses verlängerten Plättchens (34) hin allmählich zunimmt.

15. Der Ausleger zum Verstauen eines Kabels nach Anspruch 1, wobei ein Anschlagteil (86) am Trägersitz (16) befestigt ist und mindestens einen ersten Anschlag (88) aufweist, das dritte Befestigungselement (22) einen ersten Vorsprung (90a) aufweist, der entsprechend dem mindestens einen Anschlag (88) angeordnet ist, der Trägersitz (16) mit diesem ersten Vorsprung (90a) des dritten Befestigungselements (22) mit dem mindestens einen ersten Anschlag (88) des Anschlagteils (86) in Berührung kommt.

16. Der Ausleger zum Verstauen eines Kabels nach Anspruch 15, wobei das Anschlagteil (86) einen Verlängerungsarm (92) und einen zweiten Anschlag (94) aufweist, wobei dieser zweite Anschlag (94) am Verlängerungsarm (92) befestigt und der zweite Anschlag (94) so angeordnet ist, um mit einer Seite des ersten Stützteils (24) in Berührung zu kommen.

17. Der Ausleger zum Verstauen eines Kabels nach Anspruch 15, wobei das Anschlagteil (86) zwei erste Anschläge (88a, 88b), zwei Verlängerungsarme (92a, 92b) und zwei zweite Anschläge (94a, 94b) aufweist, die an den beiden Verlängerungsarmen (92a, 92b) befestigt sind; einer der beiden ersten Anschläge (88a, 88b) mit dem ersten Vorsprung (90a) des dritten Befestigungselements (22) und einer der zweiten Anschläge (94a, 94b) mit dem ersten Stützteil (24) in Berührung kommt.

18. Der Ausleger zum Verstauen eines Kabels nach Anspruch 17, wobei beide der zwei Verlängerungsarme (92a, 92b) des Anschlagteils (86) ein auslösendes Teil (96a/96b) aufweisen, das dritte Befestigungselement (22) einen zweiten Vorsprung (90b) aufweist, der entsprechend dem auslösenden Teil (96a/96b) von einem der beiden Verlängerungsarme (92a, 92b) angeordnet ist, der zweite Vorsprung (90b) mit dem auslösenden Teil (96a/96b) in Berührung kommt, um die zweiten Anschläge (94a, 94b) vom ersten Stützteil (24) wegzubewegen.

19. Der Ausleger zum Verstauen eines Kabels nach Anspruch 1, weiter bestehend aus einem ersten gleitbaren Mechanismus (72) und aus einem zweiten gleitbaren Mechanismus (74); der erste gleitbare Mechanismus (72) eine erste feste Schiene (76) und eine erste bewegliche Schiene (78) aufweist, die sich relativ zur ersten festen Schiene (76) der Länge nach verschieben läßt; der zweite gleitbare Mechanismus (74) eine zweite feste Schiene (80) und eine zweite bewegliche Schiene (82) aufweist, die sich relativ zur zweiten festen Schiene (80) der Länge nach verschieben läßt; das erste Befestigungselement (18) an der ersten festen Schiene (76) befestigt und in der ersten Position gesichert ist; das zweite Befestigungselement (20) an der ersten beweglichen Schiene (78) befestigt und in der zweiten Position angeordnet ist, wobei diese zweite Position variabel ist, wenn die erste bewegliche Schiene (78) relativ zur ersten festen Schiene (76) verschoben wird; das dritte Befestigungselement (22) an der zweiten festen Schiene (80) des zweiten gleitbaren Mechanismus (74) befestigt und in der dritten Position gesichert ist.

## Revendications

1. Un bras de gestion des câbles comprenant :
un premier bras (10) ;
un second bras (12) ;
une armature (14) raccordée de façon pivotante entre les premier et
second bras (10, 12) ;
une plaque d'extension (34) attachée au fond de l'armature (14) ;
un siège de support (16) ayant une plaque de support (38) ;
un premier élément de support (18) raccordé au premier bras (10) ;
un deuxième élément de support (20) raccordé au second bras (12) ;
un troisième élément de support (22) raccordé au siège de support (16) ;
le bras de gestion des câbles installé sur un premier ensemble coulissant (72) et un second ensemble coulissant (74) ;
le premier bras (10) raccordé au premier ensemble coulissant (72) par le premier élément de connexion (18) ;
le second bras (12) raccordé au premier ensemble coulissant (72) par le deuxième élément de support (20) ; et
le troisième élément de support (22) raccordé au second ensemble coulissant (74) par le siège de support (16) ;
un premier élément de support (24) raccordé de façon pivotante au siège de support (16) et en contact avec la plaque de support (38) du siège de support (16) ;
un second élément de support (26) raccordé de façon coulissante au premier élément de support (24) et rétractable par rapport au premier élément de support (24) ;
un premier élément élastique (28) raccordé entre les premier et second éléments de support (24, 26) de sorte que le second élément de support (26) est tiré par rapport au premier élément de support (24) par le premier élément élastique (28) ;
une glissière (30) raccordée de façon pivotante au fond de l'armature (14) et en contact avec la plaque d'extension (34), la glissière (30) raccordé de façon coulissante au second élément de support (26), et
le premier bras (10) étant situé sur une première position fixe grâce au premier élément de support (18), le second bras (12) étant situé sur une seconde position mobile grâce au deuxième élément de support (20), le siège de support (16) étant situé sur une troisième position fixe grâce au troisième élément de support (22), quand le deuxième élément de support (20) du second bras (12) est éloigné du premier élément de support (18) du premier bras (10), l'armature (14) est éloignée du siège de support (16) par le mouvement coulissant de la glissière (30) le long du second élément de support (26), la glissière (30) déplace le second élément de support (26) pour s'étendre par rapport au premier élément de support (24), et le premier élément de support (24) pivote par rapport au siège de support (16).

2. Le bras de gestion des câbles selon la revendication 1, dans lequel le second élément de support (26) a un premier bloc (60) qui est situé en correspondance avec la glissière (30), la glissière (30) entre en contact avec le premier bloc (60) et entraîne le second élément de support (26) pour se déplacer par rapport au premier élément de support (24).

3. Le bras de gestion des câbles selon la revendication 2, dans lequel le second élément de support (26) a un second bloc (62) qui est situé en correspondance avec la glissière (30), la glissière (30) coulisse entre le premier bloc (60) et le second bloc (62).

4. Le bras de gestion des câbles selon la revendication 1, dans lequel le premier élément de support (24) a un premier crochet (56) et le second élément de support (26) a un second crochet (58), le premier élément élastique (28) est raccordé entre les premier et second crochets (56, 58).

5. Le bras de gestion des câbles selon la revendication 1, dans lequel le siège de support (16) est raccordé de façon pivotante au troisième élément de support (22) par un premier élément pivotant (48), le premier élément de support (24) est raccordé de façon pivotante au siège de support (16) par un second élément pivotant (50).

6. Le bras de gestion des câbles selon la revendication 5, comprenant en outre un second élément élastique (66) raccordé entre le premier élément de support (24) et le siège de support (16), le premier élément de support (24) retourne à l'intérieur d'une plage angulaire prédéterminée par rapport au siège de support (16) grâce au second élément élastique (66).

7. Le bras de gestion des câbles selon la revendication 6, dans lequel le second élément élastique (66) a une partie de défilement (68) qui est assemblée au premier élément pivotant (48) et la partie de défilement (68) a une première patte élastique (70) s'étendant à partir de là qui est en contact avec le premier élément de support (24).

8. Le bras de gestion des câbles selon la revendication 5, dans lequel la plaque de support (38) du siège de support (16) est horizontale et a une périphérie ronde dont le centre est situé à un axe du second élément pivotant (50), une cheville (52) est raccordée au premier élément de support (24) qui est déplaçable le long de la périphérie ronde du siège de support (16) grâce à la cheville (52).

9. Le bras de gestion des câbles selon la revendication 1, dans lequel le siège de support (16), le troisième élément de support (22) et le premier élément de support (24) sont raccordés les uns aux autres de façon pivotante grâce au premier élément pivotant (48).

10. Le bras de gestion des câbles selon la revendication 9, comprenant en outre un second élément élastique (202) raccordé entre le siège de support (16) et le premier élément de support (24), de sorte que le premier élément de support (24) retourne à l'intérieur d'une plage angulaire prédéterminée par rapport au siège de support (16) grâce au second élément élastique (202).

11. Le bras de gestion des câbles selon la revendication 10, dans lequel le siège de support (16) a une partie d'attache (200) pour attacher le second élément élastique (202), le second élément élastique (202) a deux secondes pattes élastiques (204) qui sont respectivement en contact avec les deux côtés du premier élément de support (24).

12. Le bras de gestion des câbles selon la revendication 9, dans lequel le siège de support (16) a une fente incurvée (206) dont le centre est situé à un axe du premier élément pivotant (48), le premier élément de support (24) est situé de façon mobile dans la fente incurvée (206) grâce à une cheville (208).

13. Le bras de gestion des câbles selon la revendication 1, dans lequel la plaque d'extension (34) a une nervure (36) s'étendant à partir de là vers le bas et la rainure (36) est en contact avec la glissière (30).

14. Le bras de gestion des câbles selon la revendication 13, dans lequel l'épaisseur de la rainure (36) est graduellement augmentée à partir d'un centre près d'un rebord du fond de la plaque d'extension (34) jusqu'à deux côtés de la plaque d'extension (34).

15. Le bras de gestion des câbles selon la revendication 1, dans lequel un élément de butée (86) est raccordé au siège de support (16) et a au moins une première butée (88), le troisième élément de support (22) a une première saillie (90a) située en correspondance avec la ou les premières butées (88), le siège de support (16) est en contact avec la première saillie (90a) du troisième élément de support (22) grâce à la ou aux premières butées (88) de l'élément de butée (86).

16. Le bras de gestion des câbles selon la revendication 15, dans lequel l'élément de butée (86) a un bras d'extension (92) et une seconde butée (94) qui est raccordé au bras d'extension (92), la seconde butée (94) est située pour entrer en contact avec un côté du premier élément de support (24).

17. Le bras de gestion des câbles selon la revendication 15, dans lequel l'élément de butée (86) a deux premières butées (88a, 88b), deux bras d'extension (92a, 92b), et deux secondes butées (94a, 94b) qui sont raccordées aux deux bras d'extension (92a, 92b), l'une des deux premières butées (88a, 88b) est en contact avec la première saillie (90a) du troisième élément de support (22), l'une des deux secondes butées (94a, 94b) est en contact avec le premier élément de support (24).

18. Le bras de gestion des câbles selon la revendication 17, dans lequel chacun des deux bras d'extension (92a, 92b) de l'élément de butée (86) a une partie de déclenchement (96a/96b), le troisième élément de support (22) a une seconde saillie (90b) qui est située en correspondance avec la partie de déclenchement (96a/96b) de l'un des deux bras d'extension (92a, 92b), la seconde saillie (90b) entre en contact avec la partie de déclenchement (96a/96b) pour éloigner les secondes butées (94a, 94b) du premier élément de support (24).

19. Le bras de gestion des câbles selon la revendication 1 comprenant en outre un premier ensemble coulissant (72) et un second ensemble coulissant (74), le premier ensemble coulissant (72) ayant un premier rail fixe (76) et un premier rail mobile (78) qui est longitudinalement mobile par rapport au premier rail fixe (76), le second ensemble coulissant (74) ayant un second rail fixe (80) et un second rail mobile (82) qui est longitudinalement mobile par rapport au second rail fixe (80), le premier élément de support (18) raccordé au premier rail fixe (76) et attaché à la première position, le deuxième élément de support (20) raccordé au premier rail mobile (78) et situé à la seconde position qui est variable quand le premier rail mobile (78) est déplacé par rapport au premier rail fixe (76), le troisième élément de support (22) raccordé au second rail fixe (80) du second ensemble coulissant (74) et attaché à la troisième position.
